Europäisches Patentamt

European Patent Office

Office européen des brevets

(19)

(11) Publication number: **0 153 854 B1**

(12)

# EUROPEAN PATENT SPECIFICATION

(45) Date of publication of patent specification: **02.05.91**  (51) Int. Cl.⁵: **G03F 1/00**

(21) Application number: **85301231.8**

(22) Date of filing: **25.02.85**

Divisional application 88201038 filed on 20.05.88.

(54) Process for forming a pattern film.

(30) Priority: **29.02.84 JP 38131/84**

(43) Date of publication of application:
**04.09.85 Bulletin 85/36**

(45) Publication of the grant of the patent:
**02.05.91 Bulletin 91/18**

(84) Designated Contracting States:
**DE FR GB**

(56) References cited:
**EP-A- 0 075 949**

**PATENT ABSTRACTS OF JAPAN, vol. 3, no. 6
(E-85), 22nd January 1979; & JP-A-53 135 276
(MITSUBISHI DENKI K.K.) 25-11-1978**

**PATENT ABSTRACTS OF JAPAN, vol. 7, no.
76 (E-167)[1221], 30th March 1983; & JP-A-58
6133 (MITSUBISHI DENKI K.K.) 13-01-1983**

**NUCLEAR INSTRUMENTS AND METHODS,
vol. 182/183, 1981, pages 297-302, North-
Holland Publishing Co., Amsterdam, NL; W.
MÖLLER et al.: "Carbon buildup by ion-
induced polymerization under 100-400 keV H,
He, and Li bombardment"**

(73) Proprietor: **SEIKO INSTRUMENTS INC.
31-1, Kameido 6-chome Koto-ku
Tokyo 136(JP)**

(72) Inventor: **Nakagawa, Yoshimoto c/o SEIKO IN-
STRUMENTS &
ELECTRONICS Ltd 6-31-1,Kameido
Koto-ku Tokyo(JP)**
Inventor: **Kaito, Takashi c/o SEIKO INSTRU-
MENTS &
ELECTRONICS Ltd 6-31-1, Kameido
Koto-ku Tokyo(JP)**
Inventor: **Hojo, Hisao c/o SEIKO INSTRU-
MENTS &
ELECTRONICS Ltd 6-31-1, Kameido
Koto-ku Tokyo(JP)**
Inventor: **Yamamoto, Masahiro c/o SEIKO IN-
STRUMENTS &
ELECTRONICS Ltd 6-31-1, Kameido
Koto-ku Tokyo(JP)**

(74) Representative: **Caro, William Egerton et al
J. MILLER & CO. Lincoln House 296-302 High
Holborn
London WC1V 7JH(GB)**

## Description

This invention relates to processes for forming pattern films required, for example, in correcting photomasks during the fabrication of semiconductor devices.

Masks and reticules for use in the manufacture of semi-conductors are made by etching patterns through exposure to light. The process presents problems because of defects the patterns tend to develop. These defects are classified into two groups, unwanted pattern portions left unremoved which are called black-spot defects and portions needed but unintentionally etched away, called white-spot defects.

In JP-A-53-135276 there is disclosed a process for forming a pattern film on a substrate comprising maintaining a vapour of an organic compound in contact with the substrate and irradiating a specific portion of the substrate with a beam so as to cause the organic compound to form a pattern film on the specific portion. This enables white-spot defects to be repaired.

However, the beam disclosed in JP-A-53-135276 is an electron beam. As a result, there is considerable electron scattering which makes it difficult to achieve a precise and economical repair. Moreover, the use of an electron beam results in a pattern film which is weakly bonded to the substrate.

The kinds of organic compound thus far proposed for use in the known process have included vacuum pump oils, organo-metallic compounds such as trimethylaluminium, and bisbenzene complexes such as [Cr(C$_6$H$_6$)$_2$], When vacuum pump oil is used in remedying white-spot defects, its low vapour pressure at ordinary temperature (300°K), i.e. below $10^{-6}$ Torr, makes the supply of the oil constituent molecules for film forming by polymerisation or carbonisation insufficient. Consequently, the rate of film build-up to a desired thickness is low. If the vacuum pump oil were to be heated to raise its vapour pressure for a faster increase in film thickness, it would condense on the sample surface. The condensate would then give incompletely polymerised or carbonised portions along the boundaries between ion beam irradiated and non-irradiated areas, bringing difficulties in film formation and other unfavourable effects. The use of organo-metallic compounds and bisbenzene complexes also has drawbacks. When the vapour pressure in the vicinity of the sample is low, the build-up of the film progresses slowly, and an attempt to raise the pressure for adequately fast film build-up will invite difficulties such as scattering of the ion beam out of focus, added load on the vapour discharge system, and adverse effects upon the ion source. Also, the organic compounds containing metallic atoms are often so toxix or unstable that they pose handling problems.

The present invention seeks to overcome the difficulties of the conventional processes for forming pattern films by forming a pattern film of less than one micron thickness rapidly by the use of an organic compound with good stability and extremely low toxicity.

According to the present invention, there is provided a process for forming a pattern film which comprises irradiating a specific portion of a sample with a beam in an atmosphere where the vapour of an organic compound is present, thereby polymerising or carbonising the organic compound on the specific portion to form a desired pattern film thereon characterised in that said organic compound has a vapour pressure of 300°K between 1 x $10^{-4}$ and 5 x $10^{-3}$ Torr, the said vapour being brought into contact with the sample by directing a vapour stream of the organic compound at a specific portion of the sample, the said beam being a focused ion beam.

Said organic compound may be a tri-or tetracyclic aromatic compound. Preferably said organic compound has a molecular weight between 200 and 400.

Said organic compound may consist mainly of a hydrocarbon compound and is free from any metal atom. Said organic compound may be phenanthrene, pyrene, methylphenanthrene, fluoranthene, anthrone or triphenylmethane.

The number of organic compound molecules reacted by irradiation with one ion must be between 2 and 7. Average current density of irradiation with an ion beam is between 1 x $10^{-3}$ and 1 x $10^{-5}$ A.cm$^2$. Thus it is necessary that the organic compound molecules to be polymerised or carbonised are supplied to a support plate at a rate between 1 x $10^{13}$ and 1 x $10^{16}$ atoms/cm$^2$ sec. If the organic compound molecules are supplied at a rate of 1 x $10^{13}$ atoms/cm$^2$ sec or below, there is too great a volume of irradiation by the low beam. The rate of pattern film build-up to the desired thickness is low because of the spattering effect. Thus the pattern film is not formed on the support plate which is spatter etched. On the other hand, if the organic compound molecules are supplied at a rate of $10^{16}$ atoms/cm$^2$ sec. or above, the adherence of the pattern film on the support plate and its light shielding property are insufficient.

The invention is illustrated, merely by way of example, in the accompanying drawings, in which:-
Figure 1 is a plan view of part of a photomask having white-spot defects;
Figure 2, consisting of Figures 2a and 2b, shows sectional view of examples of correcting white-spot defects of a photomask by a process according to the present invention;

Figure 3a shows a pattern film formed using an organic compound having a vapour pressure of $1 \times 10^{-4}$ Torr or below at $300°$ K, Figure 3b shows a pattern film formed by a process according to the present invention using an organic compound having a pressure of between $1 \times 10^{-4}$ and $5 \times 10^{-3}$ Torr at $300°$ K, and Figure 3c shows a pattern film formed using an organic compound having a vapour pressure of $5 \times 10^{-3}$ Torr or above at $300°$ K; and

Figure 4 illustrates a pattern film formed by a process according to the present invention:

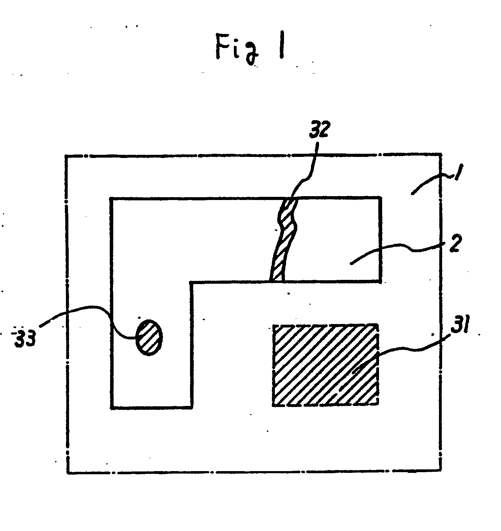

Referring to Figure 1, reference numeral 1 represents a support plate of, for example, glass, reference numeral 2 represents a pattern on the support plate 1 of chromium or other material, and reference numerals 31, 32, 33 are typical white-spot defects representing, respectively, an element omission, a disconnection, and a pinhole. These white-spot defects, which cause undesired light transmission through the mask, must be removed; the light-transmitting portions need to be treated to be as light-shielding as the rest of the pattern 2.

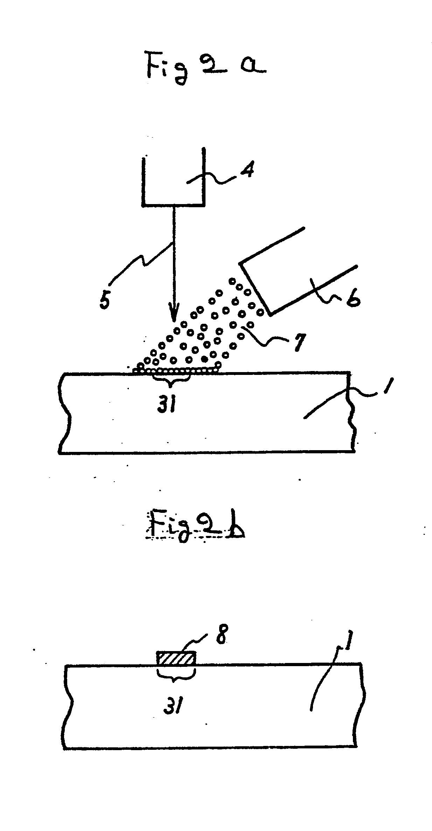

In Figure 2a the element omission 31 is corrected as follows. An ion beam generator 4 comprises a bright ion source such as a liquid metal ion source and an ion optical system for heating, polarising, and focusing ions generated by the source. The focused ion beam 5 produced by the source is used to scan the area of the element omission 31 to effect ion irradiation at a constant rate. A source 6 feeding an organic compound includes a heater that controls the source temperature and thereby adjusts the quantity of vapour 7 of the organic compound to be delivered to the element omission. In this case the temperature of the support plate 1 is at ordinary level (room temperature, $300°$ K). The vapour 7 of the organic compound mostly deposits on the support plate 1. It is polymerised or carbonised by irradiation with the ion beam 5. Figure 2b shows a pattern film 8 formed in this way on the element omission 31.

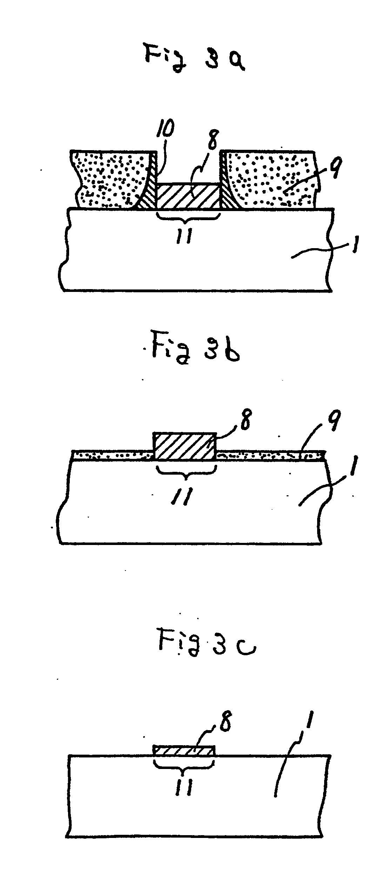

Figure 3a illustrates a pattern film formed using an organic compound having a vapour pressure of $1 \times 10^{-4}$ Torr or below at room temperature ($300°$ K). Figure 3b illustrates a pattern film formed by a process according to the present invention with an organic compound having a vapour pressure between $1 \times 10^{-4}$ and $5 \times 10^{-3}$ Torr at room temperature ($300°$ K). Figure 3c illustrates a pattern film formed using organic compound having a vapour pressure of $5 \times 10^{-3}$ Torr or above at room temperature ($300°$ K). The conditions of the ion beam 5 for irradiation and of the support plate 1 are the same in Figures 3a , 3b , 3c .

In Figure 3a , the organic compound deposited on the support plate 1 forms an organic compound layer 9 because of its low evaporation rate. Of this organic compound layer 9 the portion irradiated with the ion beam 5 is reduced in thickness to a denser solid mass, lower in height than the original layer 9 and is polymerised or carbonised to form the pattern film 8. At the same time, incomplete polymerised or carbonised organic compound layer portions 10 develop along the boundaries between the organic compound layer 9 and the pattern film 8. These portions make microfine processing difficult or can fall off where the bond strength is insufficient, producing unwanted shadows or causing other troubles in a subsequent stage of selective exposure of the pattern on a semiconductor wafer.

In Figure 3b , the vapour of an organic compound having a vapour pressure in the range as specified by the present invention, i.e. between $1 \times 10^{-4}$ and $5 \times 10^{-3}$ Torr at $300°$ K, is directed against the surface of the support plate 1. The organic compound delivered in vapour form against the support plate 1, deposits on the surface, remains there for some time, and then evaporates. Thus, while the irradiating ion beam 5 scans, a suitable amount of the organic compound vapour is supplied, and it is polymerised or carbonised by the next scan. In this manner, the pattern film 8 grows to a desired thickness, e.g. 1 micron. Outside a spot 11 at which the organic compound is directed, the organic compound vapour forms only a negligibly thin organic compound layer 9. Soon after the cut-off of the vapour supply the organic compound layer 9 will evaporate substantially completely, leaving no obstacle behind which would hamper the formation of the pattern film.

In Figure 3c the organic compound has a vapour pressure of $5 \times 10^{-3}$ Torr or above at $300°$ K and so evaporates immediately after deposition on the support plate 1. Consequently, the supply of the organic compound molecules for film forming must be $10^{15}$ atoms/cm$^2$ sec or greater so that it is necessary that the organic compound molecules are retained in a vacuum chamber. The pressure in the vacuum chamber thus increases using an ordinary vacuum system (vacuum rate of about 100 litres/sec). Therefore, the vapour of the organic compound has a deleterious influence on the ion source and the life of the apparatus. In Figure 3c the organic compound has a vapour pressure of $5 \times 10^{-3}$ Torr or above and the pattern film is formed when the pressure in the pressure chamber is $1 \times 10^{-6}$ Torr or below to avoid this influence. In this case, the volume of the organic compound is too small for the pattern film element omission to obtain an adequate rate of film build-up to the desired thickness. Using the method as illustrated in Figure 3c and a vacuum system, it is impractical to hold the pressure ($1 \times 10^{-6}$ Torr or below) in the vacuum chamber in order to prolong the life of the apparatus only using an organic compound having a vapour pressure of 1 x 10⁻³ Torr or below at 300° K. Examples of organic compounds for a process according to the present invention for forming a pattern film include tri-or tetracyclic aromatic compounds such as phenanthrene, pyrene, methylphenanthrene, fluoranthene, anthrone and triphenylmethane. These organic compounds have vapour pressures at ordinary temperature (300° K) between 1 x 10⁻⁴ and 5 x 10⁻³ Torr. Moreover, they are free from metal atoms, stable, and only slightly toxic. Organic compounds other than tri- and tetracyclic aromatic compounds but having molecular weights of 200 to 400 are useful also since their vapour pressures at ordinary temperature (300° K) are between 1 x 10⁻⁴ and 5 x 10⁻³ Torr.

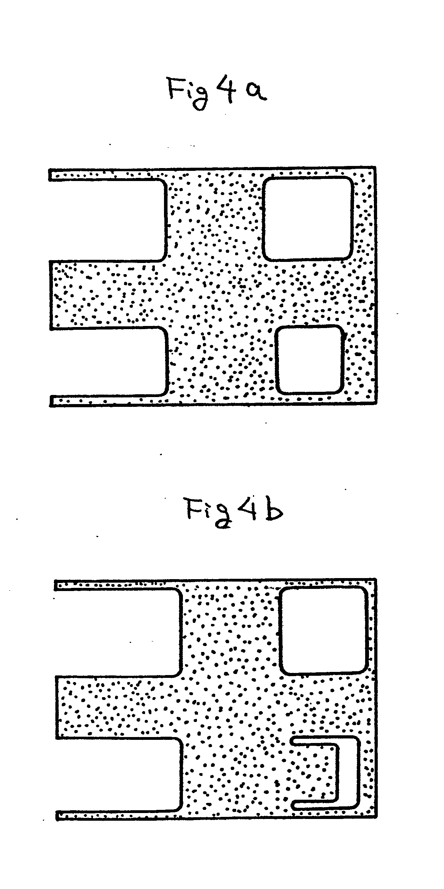

Now an example of a pattern film formed of pyrene, chosen from among the organic compounds mentioned above, will be described with reference to Figure 4. Figure 4a shows a sensible image obtained by light transmission through a sample on a support plate of clear glass and having a pattern of about 800 Å-thick chromium layer drawn thereon but yet to be formed with a pattern film by a process according to the present invention. In Figure 4b there is formed a pattern film area by a process according to the present invention, measuring 6.7 mm by 6.7 mm on an exposed glass portion 8μm square in size of the sample in Figure 4a . A focused ion beam of Ga⁺ was used for the irradiation, the acceleration voltage being 20kV, and probe current being 0.13 nA. The organic compound applied was pyrene heated to 80° C. The pattern film thus formed was 1400 Å thick and provided adequate shield against light transmission, allowing the pattern film to have sharply defined edges. The rate of thickness build-up of the pattern film was 69 Å/sec with a 200 μm-long scanning line of the ion beam at the acceleration voltage of 20 kV and with the probe current as 0.13 nA. The pattern film widths were of the order of submicrons.

The physical and chemical adhesion strength of the pattern film obtained in this way are about the same as or more than those of the chromium film, which is well known in the art. The thickness of the pattern film that provides an optical density of 2.8 was approximately 2000 Å for visible light and below 1000 Å for ultraviolet rays. Under the aforedescribed film-forming conditions, therefore, it is possible to form a 200 μm-long, submicron-wide pattern film within 20 seconds by exposure to far-ultraviolet rays. The process according to the present invention for forming a film pattern in this way is particularly suited for producing microfine pattern films. It is also possible, of course, to form a larger area of pattern film at a faster rate by irradiation with a focused ion beam of a larger diameter and with a higher probe current.

As has been described in detail above, the present invention permits pattern film formation in a single step that concludes within a short period of time and to microfine patterns less than one micron in width. This makes possible a substantial reduction in the number of process stages otherwise required. Further advantages are the ease with which the organic compound is handled and the possibility of designing an apparatus of reasonable, rationalised construction for the purpose of carrying out a process according to the present invention.

## Claims

1.  A process for forming a pattern film which comprises irradiating a specific portion of a sample with a beam in an atmosphere where the vapour of an organic compound is present, thereby polymerising or carbonising the organic compound on the specific portion to form a desired pattern film thereon characterised in that said organic compound has a vapour pressure of 300° K between 1 x 10⁻⁴ and 5 x 10⁻³ Torr, the said vapour being brought into contact with the sample by directing a vapour stream of the organic compound at a specific portion of the sample, the said beam being a focused ion beam.

2.  A process as claimed in claim 1 characterised in that said organic compound is a tri- or tetracyclic aromatic compound.

3.  A process as claimed in claim 1 or 2 characterised in that said organic compound has a molecular weight between 200 and 400.

4.  A process as claimed in any preceding claim characterised in that said organic compound consists mainly of a hydrocarbon compound and is free from any metal atom,

5.  A process as claimed in any preceding claim characterised in that said organic compound is phenanthrene, pyrene, methylphenanthrene, fluoranthene, anthrone or triphenylmethane.

## Revendications

1.  Un procédé pour former une pellicule définissant un motif qui comprend l'irradiation d'une partie spécifique d'un échantillon avec un faisceau, dans une atmosphère dans laquelle est présente la vapeur d'un composé organique, pour ainsi polymériser ou carboniser le composé organique sur la partie spécifique, afin de former sur celle-ci une pellicule formant un motif désiré, caractérisé en ce que ce composé organique a une pression de vapeur à 300° K qui est comprise entre 130 x 10⁻⁴ et 660 x 10⁻³ Pa, cette vapeur étant amenée en contact avec l'échantillon en dirigeant un écoulement de vapeur du composé organique vers une partie spécifique de l'échantillon, et le faisceau étant un faisceau d'ions focalisé.

2. Un procédé selon la revendication 1, caractérisé en ce que le composé organique est un composé aromatique tricyclique ou tétracyclique.

3. Un procédé selon la revendication 1 ou 2, caractérisé en ce que le composé organique a une masse moléculaire comprise entre 200 et 400.

4. Un procédé selon l'une quelconque des revendications précédentes, caractérisé en ce que le composé organique consiste essentiellement en un hydrocarbure et ne comporte aucun atome de métal.

5. Un procédé selon l'une quelconque des revendications précédentes, caractérisé en ce que le composé organique consiste en phénanthrène, pyrène, méthylphénanthrène fluoranthène, anthrone ou triphénylméthane.

**Ansprüche**

1. Verfahren zur Herstellung eines Rasterbildes, bei dem ein spezieller Teil einer Probe mit einem Strahl in einer Atmosphäre bestrahlt wird, in der Dampf einer organischen Verbindung vorhanden ist, wobei die organische Verbindung auf dem speziellen Teil zur Herstellung eines gewünschten Rasterfilms polymerisiert oder verkohlt wird, **dadurch gekennzeichnet,** daß die organische Verbindung einen Dampfdruck zwischen 1x10⁻⁴ und 5x10⁻³ Torr bei 300° K besitzt, daß der Dampf mit der Probe dadurch in Kontakt gebracht wird, daß ein Dampfstrahl im speziellen Teil der Probe auf die organische Verbindung gerichtet wird, und daß der Strahl ein fokussierter Ionenstrahl ist.

2. Verfahren nach Anspruch 1, **dadurch gekennzeichnet,** daß die organische Verbindung eine tri- oder tetrazyklische aromatische Verbindung ist.

3. Verfahren nach Anspruch 1 oder 2, **dadurch gekennzeichnet,** daß die organische Verbindung ein Molekulargewicht zwischen 200 und 400 besitzt.

4. Verfahren nach den vorhergehenden Ansprüchen, **dadurch gekennzeichnet,** daß die organische Verbindung im wesentlichen aus einer Kohlenwasserstoffverbindung besteht und frei von Metallatomen ist.

5. Verfahren nach den vorhergehenden Ansprüchen, **dadurch gekennzeichnet,** daß die organische Verbindung ein Phenanthren, Pyren, Methylphenanthren, Fluoranthen, Anthron oder Triphenylmethan ist.

Fig 1

Fig 2 a

Fig 2 b

Fig 3 a

Fig 3 b

Fig 3 c

Fig 4 a

Fig 4 b